Europäisches Patentamt

European Patent Office

Office européen des brevets

(19)

(11) Veröffentlichungsnummer: **0 090 820**
**B1**

(12) ## EUROPÄISCHE PATENTSCHRIFT

(45) Veröffentlichungstag der Patentschrift:
26.02.86

(51) Int. Cl.⁴: **H 01 L 27/01**

(21) Anmeldenummer: 82902975.0

(22) Anmeldetag: 05.10.82

(86) Internationale Anmeldenummer:
**PCT/DE 82/00195**

(87) Internationale Veröffentlichungsnummer:
**WO 83/01344 (14.04.83 Gazette 83/9)**

(54) **ELEKTRONISCHE DÜNNSCHICHTSCHALTUNG UND DEREN HERSTELLUNGSVERFAHREN.**

(30) Priorität: 06.10.81 DE 3139670

(43) Veröffentlichungstag der Anmeldung:
12.10.83 Patentblatt 83/41

(45) Bekanntmachung des Hinweises auf die Patenterteilung:
26.02.86 Patentblatt 86/9

(84) Benannte Vertragsstaaten:
**CH DE FR GB LI NL**

(56) Entgegenhaltungen:
**EP - A - 0 016 251**
**FR - A - 2 305 837**
**FR - A - 2 376 592**

(73) Patentinhaber: **ROBERT BOSCH GMBH, Postfach 50,
D-7000 Stuttgart 1 (DE)**

(72) Erfinder: **GRUNER, Heiko, Kehlenstrasse 1014,
CH-5712 Beinwil am See (CH)**

LIBER, STOCKHOLM 1986

## Beschreibung

### Stand der Technik

Die Erfindung geht aus von einer elektronischen Dünnschaltschaltung nach der Gattung des Hauptanspruchs. Aus der DE-A-29 06 813 ist bereits eine elektronische Dünnschichtschaltung dieser Art bekannt. Bei derartigen Dünnschichtschaltungen kann die Weichlotschicht die Bahnleitfähigkeit nur dann in ausreichendem Maße erhöhen, wenn es sich um verhältningsmäßig breite Leiterbahnen handelt. Bei feinstrukturierten Leiterbahnen dagegen reicht der spezifische Widerstand des Weichlots hierzu nicht aus. Ferner ergeben sich Schwierigkeiten bei der Aufbringung des Weichlots. Auch eignet sich die Weichlotschicht im Bereich der Anschlußkontakte nur zur Anbringung von Hybridbausteinen, die im Reflow Lötprozess in die Schaltung eingebaut werden sollen. Halbleiterelemente, die nicht mit einem Gehäuse versehen sind , können dagegen mit Hilfe der Weichlotschicht nicht in die Schaltung eingebracht werden. Auch an den nicht mit Weichlot belegten Stellen, an denen die lötbare und galvanisch verstärkbare Metallschicht freiliegt, lassen sich solche Halbleiterelemente und ihre Bonddrähte nicht ohne Schwierigkeiten anbringen.

### Vorteile der Erfindung

Die erfindungsgemäße Dünnschichtschaltung mit den kennzeichnenden Merkmalen des Hauptanspruchs hat demgegenüber den Vorteil, daß bei feinstrukturierten Leiterbahnen die Bahnleitfähigkeit durch die aufgebrachte Goldschicht in ausreichendem Maße erhöht wird und daß außerdem die Möglichkeit geschaffen wird, auch Halbleiterelemente, die nicht mit einem Gehäuse versehen sind, in der Hybridschaltung unterzubringen. Diese werden dann mittels leitfähigen Kleber auf die mit Gold belegten Anschlußbereiche aufgebracht. Mit Hilfe der Bond-Technik wird dann der elektrische Kontakt zwischen interner Halbleitermetallisierung und externer, mit Gold verstärkter Hybridschaltungsmetallisierung hergestellt.

### Zeichnung

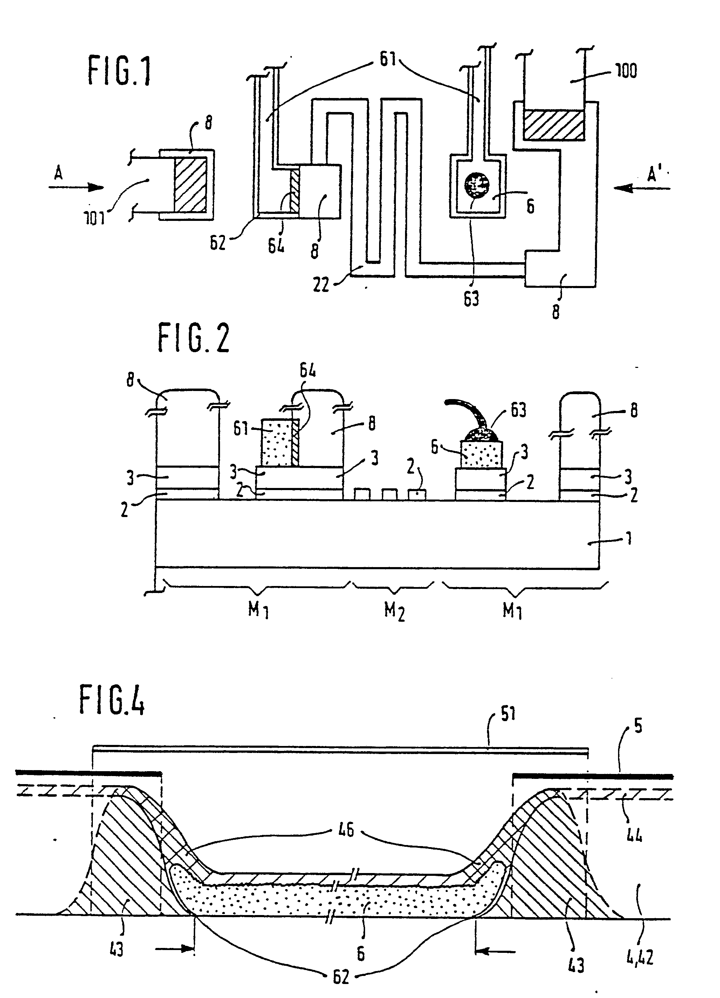

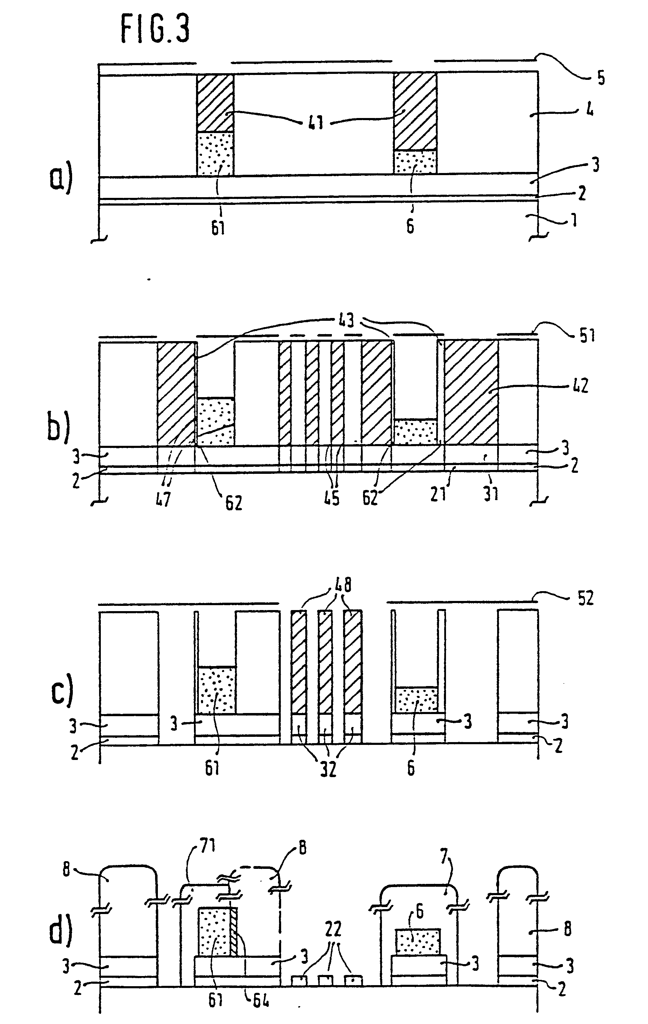

Ein Ausführungsbeispiel der erfindungsgemäßen elektronischen Dünnschichtschaltung ist in der Zeichnung dargestellt und in der nachfolgenden Beschreibung näher erläutert. Es zeigen: Figur 1 einen Ausschnits aus einer elektronischen Dünnischichtschaltung gemäß der Erfindung in der Draufsicht, Figur 2 einen Schnitt nach der Linie A-A' der Figur 1, Figur 3a bis 3d die in Herstellung begriffene elektronische Dünnschichtschaltung nach den Figuren 1 und 2 bei den verschiedenen erfindungsgemäß aus zuführenden Verfahrensschritten, Figur 4 eine Schnittdarstellung zur Veranschaulichung der Wirkung der Aufbringung einer zusätzlichen dünnen Photolackschicht nach dem Aufbringen der Goldschicht.

### Beschreibung des Ausführungsbeispiels

Bei der in den Figuren 1 und 2 dargestellten elektronischen Dünnschichtschaltung ist auf eine aus einen Isoliermaterial bestehende Substratplatte 1 eine Widerstandsschicht 2, die aus Tantaloxinitrid bestehen kann, aufgebracht, die die Substratplatte 1 teilweise bedeckt und ein erstes Muster $M_1$ und ein zweites Muster $M_2$ bildet. Das erste Muster $M_1$ definiert dabei Leiterbahnen und/oder Anschlußkontakte, fahrend das zweite Muster $M_2$ Schaltungselemente der elektronischen Dünnschichtschaltung definiert. In Bereich des ersten Musters $M_1$ ist oberhalb der Widerstandsschicht 2 eine lötbare und galvanisch verstärkbare Metallschicht 3 angeordnet, die aus Nickel bestehen kann, wobei gegebenenfalls zwischen der Widerstandsschicht 2 und der lötbaren und galvanisch verstärkbaren Metallschicht 3 eine als Diffusionssperre wirkende Zwischen schicht angeordnet sein kann. Eine solche Zwischenschicht kann beispielsweise in der in der DE-A-29 06 813 beschriebenen Weise ausgebildet und hergestellt sein. Auf Teile der lötbaren und galvanisch verstärkbaren Metallschicht 3 ist innerhalb des ersten Musters $M_1$ zur Bildung von mit Weichlot verstärkten Leiterbahnen und/oder Anschlußkontakten eine Weichlotschicht 8 aufgebracht. Auf andere, nicht mit Weichlot beschichtete Teile der lötbaren und galvanisch verstärkbaren Metallschicht 3 sind innerhalb des ersten Musters $M_1$ zur Bildung von mit Gold verstärkten Leiterbahnen und/oder Anschlußkontakten Goldschichten 6, 61 aufgebracht. An derjenigen Stelle, an der die Goldschicht 61 und die Weichlotschicht 8 aneinandergrenzen, ist eine schmale Übergangszone 64 vorgesehen, die sowohl Gold als auch Weichlot enthält und einen niederohmigen Kontakt zwischen den beiden aneinandergrenzenden Schichten 8, 61 herstellt. An der Goldschicht 6 ist bei 63 ein Bonddraht befestigt. In Figur 1 ist mit 22 derjenige Teil der Widerstandsschicht 2 bezeichnet, der ein Widerstandelenent der elektronischen Dünnschichtschaltung bildet und nicht mit weiteren Metallisierungsschichten bedeckt ist. Dieser Teil 22 der Widerstandschicht 2 bildet das zweite Muster $M_2$. Auf die Weichlotschicht 8 ist in Figur 1 bei 100 ein Kondensator, bei 101 beine Kammelektrode aufgelötet. Die Figuren 3a bis 3d zeigen in Verbindung mit Figur 4 die in Herstellung begriffene elektronische Dünnschichtschaltung gemäß der Erfindung. Gemäß Figur 3a ist auf die Substratplatte 1 zuerst eine durchgehende Widerstandsschicht 2 und auf diese Widerstandsschicht 2 eine durchgehende, lötbare und galvanisch verstärkbare Metallschicht 3 aufgebracht worden. Auf die lötbare und galvanisch verstärkbare Metallschicht 3 ist ein Photolackschicht 4 aufgebracht worden. Die Photolackschicht 4 ist mit Hilfe der Belichtungsmaske 5 an den Stellen 41 belichtet und wegentwickelt worden, so daß an den so freigelegten Stellen der Metallschicht 3 die Goldschichten 6, 61 galvanisch abgeschieden werden konnten. Die Dicke der Goldschichten kann ihrer Aufgabe angepasst werden; Wird ausschließlich gebondet, so genügt eine Goldschicht mit 1 μm Schichtdicke. Soll die Goldschicht zusätzlich die Leitfähigkeit von aus Flatzgründen sehr schmalen Leiterbahnen erhöhen, dann ist jenach Bahnbreite von 200 bis 20 μm eine Goldschichtdicke von 2 bis 6 μm erforderlich. Solche schmalen Leiterbahnen lassen sich in Löttechnik nicht mit ausreichender Leitfähigkeit herstellen.

Danach werden in einen zweiten Belichtungsprozess (Figur 3b) mit der Photomaske 51 weitere Teile 42 der Photolackschicht 4 belichtet und entwickelt, um durch Abätzen der so freigelegten Teile 31 und 21 der Metallschicht 3 und der Widerstandsschicht 2 die Schaltungsgeometrie zu erzeugen. Dieser Verfahrensablauf wird deshalb ermöglicht, weil die Goldschichten 6 und 61 in den Lackfenstern 41 auf der Metallschicht 3 und auf den unteren Teil der Photolackschicht 4, welcher die freigelegte Metallschicht 3 begrenzt, unerwartet so dicht abgeschieden werden, daß kein Ätzmittel während der Ätzzeit entlang der Grenze zwischen Gold und Photolack zur Metallschicht 3 vordringen kann.

Um eine kontakt-korrosiv verstärkte Unterätzung der Goldätzkanten 62 bei der Ätzung der Metallschicht 3 zu verhindern (wenn auf grund der schmalen Leiterbahnen dies störend ist), wurde die Belichtungsmaske 51 so gestaltet, daß an allen Goldrändern eine die Goldschicht und die Metallschicht 3 überlappende Lackbahn 43 stehen bleibt. Da weiter bei be stimmten Ätzmitteln die Anwesenheit von Gold beim Ätzprozeß eine starke Verlängerung der Ätzzeiten durch Passivierung der zu ätzenden Schichten 2, 3 bewirken kann, kann die Goldschicht vor dem Belichten der Photomaske 51 mit einer zusätzlich aufgebrachten dünnen Photolackschicht (44 in Figur 4) abgedeckt werden, z. B. durch Aufschleudern, was den Vorteil besitzt, daß auf der Goldschicht an den Kanten der Lackfenster 41 der Photolackschicht 4 eine etwas dickere Lackabdeckung 46 entsteht. Diese Lackwülste 46 bilden eine zusätzliche Sicherheit gegen ein Eindringen der Ätzmittel für die Kontaktschichtätzung und die Widerstandsschichtätzung entlang der Gold-Lackkante. Die zusätzliche Lackabdeckung der Goldschicht 6, 61 kann zwingend werden, wenn durch die durch die Anwesenheit von Gold bedingte Verlängerung der Kontaktmetallisierungsätzung die Metallschicht 3 auch an den Lackkanten der Widerstandsbahnen 45 und damit im selektiven Widerstands-Ätzmittel auch die Widerstandsschicht 2 stärker unterätzt wird, weil die Metallschicht 3 Ätzmaske für die Widerstandsschicht 2 ist.

Nach dem Ätzen der Schaltungsgeometrie erfolgt in einem dritten Belichtungsprozess (Figur 3c) mit der Photomaske 52 die Freilegung der Schaltungsteile, aus denen durch selektive Abätzung der Metallschicht 3 die Widerstände 22 erzeugt werden. Hierfür sind die Photolackbereiche 48 der Photolackschicht 4 nach der Belichtung wegentwickelt worden.

Die restliche Photolackschicht 4 wird nach dem selektiven Widerstandsätzen abgelöst. Mit Hilfe der siebgedruckten Antilötschicht 7 werden die Goldbereiche vor dem Verzinnen im Tauchbad geschützt, wobei an den Stellen, an denen es zu einer direkten Berührung von Lot und Gold kommt, die Goldabdeckung 71 einen Teil 64 der Goldschicht 61 nicht abdeckt, der sich dann in Lot löst, so daß der gewünschte niederohmige Kontakt entsteht.

Erst nach dem Laserabgleich aller Widerstände und bei Keramik-Substraten nach dem Laser-Vorritzen wird die Antilötschicht abgewaschen, die Schaltungen vereinzelt, Halbleiterbauelemente eingebondet, was durch den Bonddraht 63 angedeutet wird, und die übrigen Bauelemente gemeinsan mit den Anschlußkamm im Reflow-Prozess eingelötet.

Für die Widerstandsschicht 2 kann auch ein beliebiges Ventilmetall oder ein Ventilmetallnitrid oder ein Ventilmetalloxinitrid verwendet werden, aber auch Nickel-Chrom oder Manganin .

Für die lötbare und galvanisch verstärkbare Metallschicht 3 kann beispielsweise anstelle der Nickelschicht ein Dreischichtsystem verwendet werden, das aus der Schichtenfolge Kupfer-Eisen-Kupfer oder Kupfer-Nickel-Kupfer oder Kupfer-Kobalt-Kupfer besteht.

## Patentansprüche

1. Elektronische Dünnschichtschaltum mit einer aus einem Isoliermaterial bestehenden Substratplatte (1) mit einer die Substratplatte ( 1) teilweise bedeckenden Widerstandsschicht (2), die ein erstes Muster ($M_1$) und ein zweites Muster ($M_2$) bildet, wobei das erste Muster ($M_1$) Leiterbahnen und/oder Anschlußkontakte und das zweite Muster ($M_2$) Schaltungselemente der elektronischen Dünnschichtschaltung definiert, mit einer im Bereich des ersten Musters ($M_1$) oberhalb der Widerstandsschicht (2) angeordneten lötbaren und galvanisch verstärkbaren Metallschicht (3), wobei gegebenenfalls zwischen der Widerstandsschicht (2) und der lötbaren und galvanisch verstärkbarem Metallschicht (3) eine als Diffusionssperre wirkende Zwischenschicht angeordnet ist, und mit einer auf Teile der lötbaren und galvanisch verstärkbaren Metallschicht (3) innerhalb des ersten Musters (M₁) zur Bildung von mit Weichlot verstärkten Leiterbahnen und/oder Anschlußkontakten aufgebrachten Weichlotschicht (8) dadurch gekennzeichnet, daß auf andere, nicht mit Weichlot beschichtete Teile der lötbaren und galvanisch verstärkbaren Metallschicht (3) innerhalb des ersten Musters (M₁) zur Bildung von mit Gold verstärkten Leiterbahnen und/oder Anschlußkontakten eine Goldschicht (6, 61) aufgebracht ist, wobei an denjenigen Stellen, an denen die Goldschicht (6, 61) und die Weichlotschicht (8) aneinandergrenzen, schmale Übergangszonen (64) vorgesehen sind, die sowohl Gold als auch Weichlot enthalten und einen niederohmigen Kontakt zwischen den aneinandergrenzenden Schichten (6, 61;8) herstellen.

2. Verfahren zur Herstellung einer elektronischen Dünnschichtschaltung nach Anspruch 1, dadurch gekennzeichnet, daß auf die Substratplatte (1) zuerst eine durchgehende Widerstandsschicht (2) und auf diese Widerstandsschicht (2) - gegebenenfalls unter Zwischenfügung einer als Diffusionssperre wirkenden Zwischenschicht eine durchgehende lötbare und galvanisch verstärkbare Metallschicht (3) aufgebracht wird, daß auf die lötbare und galvanisch verstärkbare Metallschicht (3) eine Photolackschicht (4) aufgebracht wird, daß in die Photolackschicht ( 4) mit Hilfe eines ersten Belichtungs- und Entwicklungsprozesses im Bereich des ersten Muster (M₁) zur Bildung der mit Gold verstärkten Leiterbahnen und/oder Anschlußkontakte Öffnungen ( 41) eingebracht werden, daß in diesen Öffnungen ( 41) auf der lötbaren und galvanisch verstärkbaren Metallschicht (3) jeweils eine Goldschicht (6, 6l) galvanisch abgeschieden wird, daß die Photolackschicht (4) mit Hilfe eines zweiten Belichtungs- und Entwicklungsprozesses über allen denjenigen Bereichen der lötbaren und galvanisch werstärkbaren Metallschicht (3) entfernt wird, die nicht zur Grundgeometrie der Dünnschichtschaltung gehören, daß dann mit Hilfe eines Ätzprozesses, bei dem die verbleibenden Teile der Photolackschicht (4) und die Goldschichten (6, 61) als Ätzmaske dienen, die Grundgeometrie der Dünschichtschaltung ausgeätzt wird, daß dann mit Hilfe eines dritten Belichtungs- und Entwicklungsprozesses die Photolackschicht (4) über allen denjenigen Bereichen (32) der lötbaren und galvanisch verstärkbaren Metallschicht (3) entfernt wird, die dem zweiten Muster (M₂) angehören, daß dann die lötbare und galvanisch verstärkbare Metallschicht (3) im Bereich (32) des zweitem Musters (M₂) selektiv abgeätzt wird, daß hierauf die restliche Photolackschicht (4) abgelöst wird, daß dann die mit den Goldschichten (6, 61) bedeckten Bereiche des ersten Musters (M₁) mit Ausnahme jeweils eines schmalen Endbereichs (64) der Goldschichten (6, 61), an den sich ein mit Weichlot zu bedeckender Bereich des ersten Musters (M₁) anschließt, mit einer siebgedruckten Antilötschicht (7, 71) abgedeckt werden, daß dann das gesamte System in flüssiges Weichlot eingetaucht wird, um auf die nicht mit der Antilötschicht (7, 71) bedeckten Bereiche des ersten Musters (M₁ die Weichlotschicht (8) aufzubringen, und daß schließlich die Antilötschicht (7, 71) abgelöst wird.

3. Verfahren nach Anspruch 2, dadurch gekennzeichnet, daß die beim zweiten Belichtungsprozess verwendete Belichtungsmaske (51) so gestaltet wird, daß an allen Rändern der Goldschichten (6, 61) eine diese Schichten (6, 61) und die lötbare und galvanisch verstärkbare Metallschicht (3) überlappende Lackbahn ( 43) stehen bleibt.

4. Verfahren nach Anspruch 2 oder 3, dadurch gekennzeichnet, daß die galvanisch abgeschiedenen Goldschichten (6, 61) vor den zweiten Belichtungsvorgang mit einer zusätzlich aufgebrachten dünnen Photolackschicht (44) abgedeckt werden.

## Claims

1. Electronic thinfilm circuit comprising a substrate plate (1) consisting of an insulating material, including a resistance layer (2) which partially covers the substrate plate (1) and which forms a first pattern (M₁) and a second pattern (M₂), in which arrangement the first pattern (M₁) defines conductor tracks and/or connecting contacts and the second pattern (M₂) defines circuit elements of the electronic thinfilm circuit, including a solderable and galvanically reinforceable metal layer (3) which is arranged in the area of the first pattern (M₁) above the resistance layer (2), in which arrangement, if necessary, an intermediate layer acting as diffusion barrier is arranged between the resistance layer (2) and the solderable and galvanically reinforceable metal layer (3), and including a soft-solder layer (8) which is applied to parts of the solderable and galvanically reinforceable metal layer (3) inside the first pattern (M₁) for forming softsolder-reinforced conductor tracks and/or connecting contacts, characterised in that a gold layer (6, 61) is applied to other parts, not coated with soft solder, of the solderable and galvanically reinforceable metal layer (3) inside the first pattern (M₁) for forming gold-reinforced conductor tracks and/or connecting contacts, in which arrangement narrow transition zones (64), containing both gold and soft solder and producing a low-resistance contact between the adjoining layers (6,61; 8) are provided at the locations at which the gold layer (6,61) adjoins the soft-solder layer (8)

2. Method for producing an electronic thinfilm circuit according to Claim 1, characterised in that first a continuous resistance layer (2) is applied to the substrate plate (1) and a continuous solderable and galvanically reinforceable metal layer (3) is applied to this resistance layer (2) - if necessary with insertion of an intermediate layer acting as diffusion barrier, that a photoresist layer (4) is applied to the solderable and galvanically reinforceable metal layer (3), that openings (41) are produced in the photoresist layer (4) with the aid of a first exposure and development process in the area of the first pattern ($M_1$) for forming the gold-reinforced conductor tracks and/or connecting contacts, that a gold layer (6,61) is galvanically deposited in each case in these openings (41) on the solderable and galvanically reinforceable metal layer (3), that the photoresist layer (4) is removed with the aid of a second exposure and development process over all the areas of the solderable and galvanically reinforceable metal layer (3) which do not belong to the basic geometry of the thinfilm circuit, that then the basic geometry of the thinfilm circuit is etched out with the aid of an etching process in which the remaining parts of the photoresist layer (4) and the gold layers (6,61) are used as etching mask, that then the photoresist layer (4) is removed with the aid of a third exposure and development process over all the areas (32) of the solderable and galvanically reinforceable metal layer (3) which belong to the second pattern ($M_2$) that then the solderable and galvanically reinforceable metal layer (3) is selectively etched off in the area (32) of the second pattern ($M_2$), that this is followed by removing the residual photoresist layer (4), that then the areas of the first pattern ($M_1$) which are covered with the gold layers (6,61), excepting in each case a small end zone (64) of the gold layers (6,61) which adjoin an area to be covered with soft solder of the first pattern ($M_1$) are covered with a screen-printed solder-protection layer (7,71), that then the entire system is immersed in liquid soft solder in order to apply the soft-solder layer (8) to the areas not covered with the solder-protection layer (7,71) of the first pattern ($M_1$) and that, finally, the solder-protection layer (7,71) is removed.

3. Method according to Claim 2, characterised in that the exposure mask (51) used in the second exposure process is shaped in such a manner that a resist track (43) remains at all edges of the gold layers (6,61) which overlaps these layers (6,61) and the solderable and galvanically reinforceable metal layer (3).

4. Method according to Claim 2 or 3, characterised in that the galvanically deposited gold layers (6,61) are covered with an additionally applied thin photoresist layer (44) before the second exposure process.

**Revendications**

1.- Circuit électronique à couche mince , avec une plaque de de substrat (1) constituée d'un materiau isolant, avec une couche résistante (2)recouvrant partiellement la plaque de substrat (1)et qui forme un Dremier modèle ($M_1$) ainsi qu'un second modèle ($M_2$), le premier modèle ($M_1$) définissant des pistes conductrices et/ou des contacts de raccordement, tandis que le second modèle ($M_2$) définit des éléments du circuit électronique à couche mince, avec une couche métallique (3), susceptible d'être brasée et renforcée galvaniquement, disposée au-dessus de la couche résistante (2) dans la zone du premier modèle ($M_1$), une couche intermédiaire jouant le rôle de barrière de diffusion étant éventuellement disposée entre la couche résistante (2) et la couche métallique (3) susceptible d'être brasée et renforcée galvaniquement, et avec une couche de brasage tendre (8) déposée sur des parties de la couche métallique (3) susceptible d'être brasée et renforcée galvaniquement, à l'intérieur du premier modèle ($M_1$), pour constituer des pistes conductrices et/ou des contacts de raccordement renforcés avec du brasage tendre, circuit caractérisé en ce qu'une couche d'or (6, 61) est déposée sur d'autres parties, non recouvertes de brasage tendre, de la couche métallique (3) susceptible d'être brasée et renforcée galvaniquement, à l'intérieur du premier modèle ($M_1$), pour constituer des pistes conductrices et/ou des contacts de raccordement renforcés avec de l'or, d'étroites zones de transition (64) étant prévues aux endroits où la couche d'or (6, 61) et la couche de brasage tendre (8) sont contigües, ces zones de transition contenant aussi bien l'or que du brasage tendre, et établissant un contact de basse résistance ohmique entre ces couches contigües (6, 61; 8).

2.- Procédé pour la fabrication d'un circuit électronique à couche mince selon la revendication 1, procédé caractérisé en ce que, on dépose tout d'abord sur la plaque de substrat (1) une couche résistante continue (2) et qu'on dépose sur cette couche résistante (2), éventuellement avec interposition d'une couche intermédiaire jouant le rôle de barrière de diffusion, une couche métallique continue (3) susceptible d'être brasée et renforcée galvaniquement, en ce qu'on dépose sur la couche métallique (3) susceptible d'être brasée et renforcée galvaniquement, une couche de photo-laque (4), en ce qu'on ménage dans la couche de photo-laque (4), à l'aide d'un premier processus d'exposition à la lumière et de développement, des ouvertures (41) dans la zone du premier modèle ($M_1$), pour constituer les pistes conductrices et/ou les contacts de raccordement renforcés avec de l'or, en ce qu'on dépose galvaniquement dans chacune de ces ouvertures (41), sur la couche métallique (3) susceptible d'être brasée et renforcée galvaniquement, une couche d'or (6, 61), en ce qu'on enlève la couche de photo-laque (4), à l'aide d'un second processus d'exposition à la lumière et de développement, sur toutes les zones de la couche métallique (3), susceptible d'être brasée et renforcée galvaniquement, qui n'appartiennent pas à la géomètrie de base du circuit à couche mince, en ce qu'ensuite, à l'aide d'un processus d'attaque chimique, dans lequel les parties restantes de la couche de photo-laque (4) et les couches d'or (6, 61) jouent le rôle de masques, on obtient par attaque chimique la géomètrie de base du circuit à couche mince, puis on enlève ensuite, à l'aide d'un troisième processus d'exposition à la lumière et de développement, la couche de photo-laque (4) sur toutes les zones (32) de la couche métallique (3) susceptible d'être brasée et renforcée galvaniquement, qui appartiennent au second modèle ($M_2$), puis on enlève sélectivement par attaque chimique la couche métallique (3), susceptible d'être brasée et renforcée galvaniquement, dans la zone (32) du second modèle ($M_2$), puis on dissout la couche de photo-laque résiduaire (4), et ensuite on recouvre par sérigraphie avec une couche anti-brasage (7, 71) les zones du premier modèle ($M_1$) recouvertes avec les couches d'or (6. 61). à l'exception toutefois d'une étroite zone terminale, (64) dans chacune de ces couches d'or (6, 61), auxquelles se raccorde une zone du premier modèle ($M_1$) devant être recouverte de brasage tendre, puis l'ensemble du système est immergé dans du brasage tendre liquide pour déposer la couche de brasage tendre (8) sur les zone du premier modèle ($M_1$) non recouvertes par la couche anti-brasage (7, 71), et finalement on dissout la couche anti-brasage (7 71).

3.-Procédé selon la revendication 2, caractérisé en ce que les masques (51) utilisés lors du second processus d'exposition à la lumière, sont prévus de façon qu'ils laissent subsister sur toutes les bordures des cou ches d'or (6, 61) une piste de laque (43) empiètant sur ces couches (6, 61) et sur la couche métallique (3) susceptible d'être brasée et renforcée galvaniquement.

4.-Procédé selon revendication 2 ou 3, caractérisé en ce que les couches d'or (6, 61) déposées galvaniquement sont recouvertes avant le second processus d'exposition à la lumière d'une couche mince de photolaque (44) déposée en surplus.

FIG.1

A → A'

FIG.2

M₁ M₂ M₁

FIG.4

# FIG.3

a)

b)

c)

d)